Europäisches Patentamt

European Patent Office

Office européen des brevets

(11) Veröffentlichungsnummer: **0 377 067**

**A1**

(12) **EUROPÄISCHE PATENTANMELDUNG**

(21) Anmeldenummer: **89100171.1**

(22) Anmeldetag: **05.01.89**

(51) Int. Cl.⁵: **B01D 71/30, H05K 5/02**

(43) Veröffentlichungstag der Anmeldung:
**11.07.90 Patentblatt 90/28**

(84) Benannte Vertragsstaaten:
**AT BE CH DE ES FR GB GR IT LI LU NL SE**

(71) Anmelder: **W.L. Gore & Associates GmbH
Hermann-Oberth-Strasse 22
D-8011 Putzbrunn(DE)**

(72) Erfinder: **Hofner, Harald
Wolfratshauser Strasse 292
D-8000 München 71(DE)**
Erfinder: **Hölscher, Theodor
Altmühlstrasse 12
D-8400 Regensburg(DE)**
Erfinder: **Gottardi, Alessandro
Via Val d'Intelvi 4
I-20152 Milano(IT)**

(74) Vertreter: **Klunker . Schmitt-Nilson . Hirsch
Winzererstrasse 106
D-8000 München 40(DE)**

(54) Sperrvorrichtung für abgedichtete Gehäuse.

(57) Zum Absperren von mit einer Be- und Entlüftung versehenen abgedichteten Gehäusen gegen Wassereintritt wird eine Sperrvorrichtung vorgeschlagen, die aus einem Trägerkörper (104, 105) und einer in dem Trägerkörper nicht-eben ausgebildeten und/oder angeordneten Membran (109) besteht. Die Membran ist gasdurchlässig jedoch wasserundurchlässig. Auf der Außenseite befinden sich in dem Trägerkörper mehrere Flüssigkeitsablaufkanäle (116), die derart angeordnet sind, daß sich möglicherweise auf der Membran sammelndes Wasser, das sich aufgrund der nicht-ebenen Anordnung der Membran an bestimmten Stellen sammelt, nach außen abläuft und damit die Gasdurchlässigkeit der Membran gewährleistet.

Fig. 2

## Sperrvorrichtung für abgedichtete Gehäuse

Die Erfindung betrifft eine Sperrvorrichtung für abgedichtete Gehäuse, bestehend aus einem Trägerkörper mit einer Luftdurchtrittsöffnung, in deren Bereich eine wasserundurchlässige und gleichzeitig gasdurchlässige Kunststoffmembran angebracht ist.

In vielen Bereichen der Technik stellt sich das Problem Bauteile oder Baugruppen, die in abgedichteten Gehäusen angeordnet sind, zum Beispiel in Gehäuse eingefaßte elektronische Bauteile, aber auch Behälter für gasende Flüssigkeiten, mit einer Be- oder Entlüftung zu versehen, damit zum Beispiel anderweitig in das Gehäuse eindringende Luft aus dem Gehäuse entweichen kann oder Luft in das Gehäuse eindringen kann, um ein Vakuum in dem Gehäuse zu vermeiden. Solche abgedichteten und mit einer Be- und Entlüftung versehene Gehäuse finden u.a. auch in der Automobiltechnik Verwendung, zum Beispiel als Gehäuse für Elektromotoren (Fensterheber, Schiebedachmotoren und dergleichen), elektrische Hupen oder dergleichen. Die einfachste Form einer Be- und Entlüftungseinrichtung ist ein kleines Loch in dem Gehäuse. Um das Eindringen von Feuchtigkeit und Schmutz durch die Lüftungsöffnung in das Gehäuse zu vermeiden, bietet es sich an, die Lüftungsöffnung mit Hilfe einer staub- und wasserdichten, jedoch gasdurchlässigen Membran zu verschließen. Man kann daran denken, als Sperrvorrichtung für ein abgedichtetes, mit einer Lüftungsöffnung ausgestattetes Gehäuse in Form eines eine gasdurchlässige Membran aufnehmenden separaten Trägerkörpers auszubilden, welcher in die Lüftungsöffnung des Gehäuses eingesetzt wird.

Es liegt auf der Hand, für solche Sperrvorrichtungen eine wasserundurchlässige, jedoch gasdurchlässige Membran in einem Trägerkörper einzuspannen, insbesondere dann, wenn derartige Membranen zur Verfügung stehen (eine wasserundurchlässige jedoch gasdurchlässige Membran besteht zum Beispiel aus PTFE-Material und wird von der Anmelderin unter der Bezeichnung GORE-TEX (Warenzeichen) vertrieben).

Problematisch sind derartige Sperrvorrichtungen jedoch in so fern, als die Lage der Membran nicht willkürlich gewählt werden kann, sondern die Membran so angeordnet sein muß, daß sich auf ihr kein Wasser ansammeln kann, welches die Gasdurchlässigkeit der Membran beseitigen würde. Aus diesen Gründen wurden abgedichtete Gehäuse und/oder Sperrvorrichtungen für solche Gehäuse bislang derart individuell für den jeweiligen Anwendungsfall konstruiert, mit der Vorgabe, daß die Membran nicht horizontal orientiert war. Aufgabe der Erfindung ist es, eine Sperrvorrichtung der eingangs genannten Art anzugeben, die für verschiedenste Zwecke einsetzbar ist und ungeachtet ihrer Lage nach der Montage des Gehäuses zuverlässig funktioniert, d.h. Wasser und andere Flüssigkeiten vom Inneren des Gehäuses abhält, jedoch Gas in beide Richtungen durchläßt.

Diese Aufgabe wird bei einer Sperrvorrichtung der eingangs genannten Art erfindungsgemäß dadurch gelöst, daß die Membran nicht-eben ausgebildet und/oder angeordnet ist und mindestens ein Flüssigkeitsablaufkanal vorhanden ist.

Die Erfindung umfaßt also zwei Maßnahmen: zum einen die nicht-ebene Ausbildung und/oder Anordnung der Membran. Durch diese Maßnahme wird erreicht, daß sich nicht auf der gesamten Oberfläche der Membran Wasser ansammeln und dadurch die Gasdurchlässigkeit der Membran beseitigen kann. Zum anderen wird durch den Flüssigkeitablaufkanal vermieden, daß sich möglicherweise so viel Wasser auf der Membran ansammelt, daß diese vollständig unter Flüssigkeit steht und deshalb trotz der nicht-ebenen Ausbildung gasundurchlässig wird.

Bei der zumindest von Teilen der Membran fernzuhaltenden Flüssigkeit handelt es sich in der Regel um Kondenswasser oder Spritzwasser.

In den Unteransprüchen sind vorteilhafte Weiterbildungen der Erfindung angegeben. In einer speziellen Ausführungsform ist vorgesehen, daß die Membran dachförmig mit mehreren ebenen Flächenabschnitten innerhalb des Trägerkörpers angeordnet ist. Alternativ dazu kann die Membran konvex gewölbt innerhalb des Trägerkörpers angeordnet sein. Konvex bezüglich des Trägerkörpers bedeutet also nach außen gewölbt. Speziell ist darunter eine kalottenförmige Formung der Membran zu verstehen.

In einer besonders bevorzugten Ausführungsform der Erfindung, die eine großflächige Membranoberfläche vorsieht, die praktisch an keiner Stelle von Flüssigkeit versperrt wird, sieht die Erfindung vor, daß die Membran als Schlauchstück ausgebildet ist, welches in einer in dem Trägerkörper ausgebildeten Kammer mit seinen Enden auf Schlauchträgerstutzen sitzt, wobei innerhalb mindestens einem Schlauchträgerstutzen eine Luftdurchtrittsöffnung in das Schlauch stück mündet. Das Schlauchstück ist ringsherum von einer Kammer umgeben, und von dieser Kammer führen mehrere Flüssigkeitsablaufkanäle nach außen. Wenn sich zum Beispiel Kondenswasser auf dem Schlauchstück bildet, tropft dieses nach unten in die Kammer ab und gelangt von der Kammer durch die Flüssigkeitsablaufkanäle nach außen.

In einer weiteren Ausgestaltung der Erfindung ist vorgesehen, daß mehrere Flüssigkeitsablaufkanäle vorhanden sind, die derart angeordnet sind, daß unabhängig von der Lage der Sperrvorrichtung mindestens immer ein Kanal tiefer liegt als die Membran. Insbesondere enthält der Trägerkörper für die Membran nach oben und zur Seite hin weisende Flüssigkeitsablaufkanäle. Bei dieser Ausführungsform der Erfindung ist die gesamte Oberfläche der Membran stets frei von Flüssigkeit.

Die Membran besteht vorzugsweise aus porösem PTFE (GORE-TEX (Warenzeichen)), da dieser Wirkstoff die erforderlichen Eigenschaften hat und flexibel und komprimierbar ist.

Damit die Membran auf keine Fall beschädigt wird, auch wenn im Bereich des abgedichteten Gehäuses beispielsweise mit Werkzeugen gearbeitet wird, sieht die Erfindung vor, die Flüssigkeitsablaufkanäle des Trägerkörpers derart auszubilden und anzuordnen, daß die Membran auf keinen Fall direkt von außen mechanisch berührt werden kann.

Trägerkörper und Gehäuse müssen dicht miteinander verbunden werden. Hierzu schlägt die Erfindung vor, den Trägerkörper mit dem Gehäuse zu verschweißen, zu verkleben, oder mittels einer Dichtung zu ver binden.

Eine besonders bevorzugte Ausführungsform der Erfindung, für die selbstständiger Schutz geltend gemacht wird, sieht vor, daß der Trägerkörper ein Unterteil und ein darauf befestigtes Oberteil besitzt, wobei das Unterteil ein Formkörper mit einer Membranauflage ist, während das Oberteil ein Deckel mit Ringflansch ist, wobei Formkörper und Ringflansch mit Ringnut bzw. Ringwulst versehen sind, und daß der äußere Randbereich der Membran als Dichtung zwischen Ringnut und Ringwulst liegt. Mit dieser Maßnahme wird eine zusätzliche Dichtung zwischen den beiden Teilen des Trägerkörpers überflüssig gemacht. Zudem ist die Klemmung gegenüber Schweißen einfach und billig. Außerdem wird die Montage erleichtert. In der Praxis wird das Oberteil des Trägerkörpers auf das die Membran tragende Unterteil aufgeschnappt. Da der äußere Rand der Membran als Dichtung dient und entsprechend am Rand des Trägerkörper-Unterteils übersteht, wird der Rand der Membran zwischen den beiden Teilen des Trägerkörpers als Dichtung eingeklemmt. Vorzugsweise sind der Formkörper des Trägerkörpers und dessen Deckel gewölbt ausgebildet, wobei zwischen beiden Teilen eine gewölbte Kammer gebildet wird, deren Höhe u.a. von der axialen Länge des Ringflansches abhängt.

Im folgenden werden Ausführungsbeispiele der Erfindung anhand der Zeichnung näher erläutert. Es zeigen:

Fig. 1 eine teilweise geschnittene Seitensicht einer Sperrvorrichtung für ein abgedichtetes Gehäuse,

Fig. 2 eine Längsschnittansicht einer zweiten Ausführungsform einer Sperrvorrichtung für ein abgedichtetes Gehäuse, und

Fig. 3 eine Längsschnittansicht einer dritten Ausführungsform einer Sperrvorrichtung für ein abgedichtetes Gehäuse.

Soweit nichts anderes gesagt ist, bestehen sämtliche Teile der unten beschriebenen Sperrvorrichtungen aus Kunststoff, und die Membranen bestehen aus porösem PTFE (GORE-TEX). Die Membranen sind gasdurchlässig, jedoch für Flüssigkeiten, insbesondere Wasser, undurchlässig.

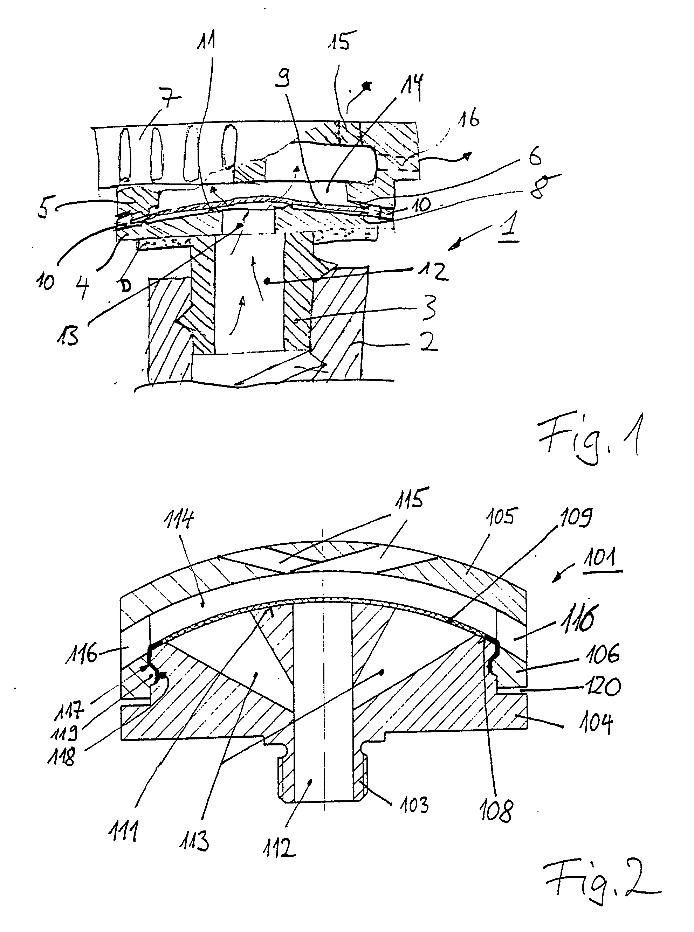

In Fig. 1 ist von einem hier nicht näher interessierenden Gehäuse aus beispielsweise Kunststoff oder Metall ein mit Innengewinde versehener Einschraubstutzen 2 dargestellt, in den ein mit einem Außengewinde versehener Einschraubstutzen 3 einer Sperrvorrichtung 1 eingeschraubt ist. Der Einschraubstutzen 2 stellt als Öffnung des Gehäuses eine Be- und Entlüftungseinrichtung dar, die Gas in beide Richtungen durchläßt, jedoch durch die Sperrvorrichtung 1 gegen den Eintritt von Flüssigkeiten, insbesondere Wasser, geschützt werden soll.

Am oberen Ende des Einschraubstutzens 3 der Sperrvorrichtung 1 befindet sich ein Trägerkörper, der aus einem Unterteil 4 und einem Oberteil 5 besteht. Im äußeren Übergangsbereich zwischen dem Einschraubstutzen 3 und dem Unterteil 4 des Trägerkörpers befindet sich eine elastische Ringdichtung D, die bei vollständig eingeschraubter Sperrvorrichtung auf der Stirnfläche des Stutzens 2 des Gehäuses 2 aufliegt.

Das Unterteil 4 des Trägerkörpers besitzt einen quadratischen Grundriß und weist eine Mittelöffnung 13 auf, die an einen Innenraum des Einschraubstutzens 3 anschließt. Die Oberseite des Unterteils 4 des Trägerkörpers ist etwas konisch ausgebildet und entspricht etwa einer vierseitigen Pyramide mit stumpfem Scheitelwinkel. An mehreren Stellen der Oberseite des Unterteils 4 befinden sich nach oben weisende Noppen, zum Beispiel Noppen 8 im äußeren Randbereich des Unterteils 4 und Noppen 11 in der Nähe der Mittelöffnung 13. Diese Noppen 8 und 11 dienen als Auflagepunkte für eine flüssigkeitsundurchlässige, jedoch gasdurchlässige PTFE-Membran 9, die dadurch auf das Unterteil 4 aufgespannt ist, daß das Oberteil 5 im Randbereich mit dem Randbereich des Unterteils 4 verschweißt ist. Unterteil 4 und Oberteil 5 des Trägerkörpers bestehen beide aus Kunststoff.

Um die Membran stramm zu halten, befinden sich den Noppen 8 im äußeren Randbereich gegenüberliegende, nach unten weisende Noppen 6 an dem Oberteil 5.

Der Innenrand des unteren Bereichs des Oberteils 5 bildet eine Kammer 14, die über die gasdurchlässige Membran 9 zusammen mit der Mittelöffnung 13 des Unterteils 4 des Trägerkörpers und dem Innenraum 12 des Einschraubstutzens 13 eine Luftdurchtrittsöffnung bildet. Links in Fig. 1 ist oberhalb des Randes der Membran 9 ein Hohlraum dargestellt, von dem aus sich Flüssigkeitsablaufkanäle (Kondenswasser-Ablaufkanäle) 10 nach außen erstrecken. Das obere Ende des Trägerkörpers enthalt einen Handgriff 7 zum Drehen der Sperrvorrichtung.

Luft kann beispielsweise aus dem abgedichteten Gehäuse in Pfeilrichtung durch den Innenraum 12 des Einschraubstutzens 3 und die Mittelöffnung 13 des Unterteils 4 des Trägerkörpers in Richtung auf die Membran 9 strömen. Im Bereich der Mittelöffnung 13 tritt die Luft dann durch die luftdurchlässige Membran in die Kammer 14 ein. Außerdem gelangt noch Luft seitlich zwischen die Membran 9 und die Oberseite des Unterteils 4, nämlich zwischen den als Auflagestellen für die Membran 9 dienenden Noppen 11 hindurch, so daß auch in den Randbereichen des Unterteils 4 Luft durch die Membran 9 in die Kammer 14 gelangt. Aus der Kammer 14 strömt die Luft nach oben durch in diesem Fall als Gasaustrittsöffnungen dienende Kanäle 15 und seitlich durch ebenfalls jetzt als Luftaustrittsöffnungen dienende Kanäle 10 und 16 nach außen.

Andererseits kann Luft (oder ein anderes Gas) über die Öffnungen 10, 15 und 16 in die Kammer 14 und von dort über die Membran 9 durch die Mittelöffnung 13 und den Innenraum 12 des Einschraubstutzens 3 in das Innere des abgedichteten Gehäuses gelangen.

Wenn sich auf der Oberseite der Membran 9 Flüssigkeit, insbesondere Kondenswasser an einigen Stellen sammeln sollte, so fließt die Flüssigkeit aufgrund der dachförmigen Anordnung der Membran 9 seitlich in den Randbereich der Membran ab und gelangt von dort über die jetzt als Flüssigkeitsablaufkanäle fungierenden Kanäle 10 nach außen aus.

Das Austreten von Flüssigkeit aus den Kanälen 12 erfolgt dann, wenn die in Fig. 1 dargestellte Sperrvorrichtung so angeordnet ist, daß die Längsmittelachse der Sperrvorrichtung vertikal und die Membran 9 mithin etwa horizontal angeordnet ist. Wird die gesamte Sperrvorrichtung um 90° gekippt angeordnet, so sammelt sich lediglich im unteren Bereich der Kammer 14 Flüssigkeit, die dann über die Kanäle 10 und die seitlich im Oberteil 5 des Trägerkörpers ausgebildeten Kanäle 16 nach außen gelangt.

Wird die Sperrvorrichtung 1 nach Fig. 1 um 180° gedreht, so fließt jegliche Flüssigkeit, die sich innerhalb der Kammer 14 sammelt, durch die oben im Oberteil 5 des Trägerkörpers ausgebildeten Kanäle 15 nach außen ab.

Die gesamte Sperrvorrichtung funktioniert also lageunabhängig, da in jeder möglichen Lage der Sperrvorrichtung sich eventuell in der Kammer 14 sammelnde Flüssigkeit nach außen abfließt.

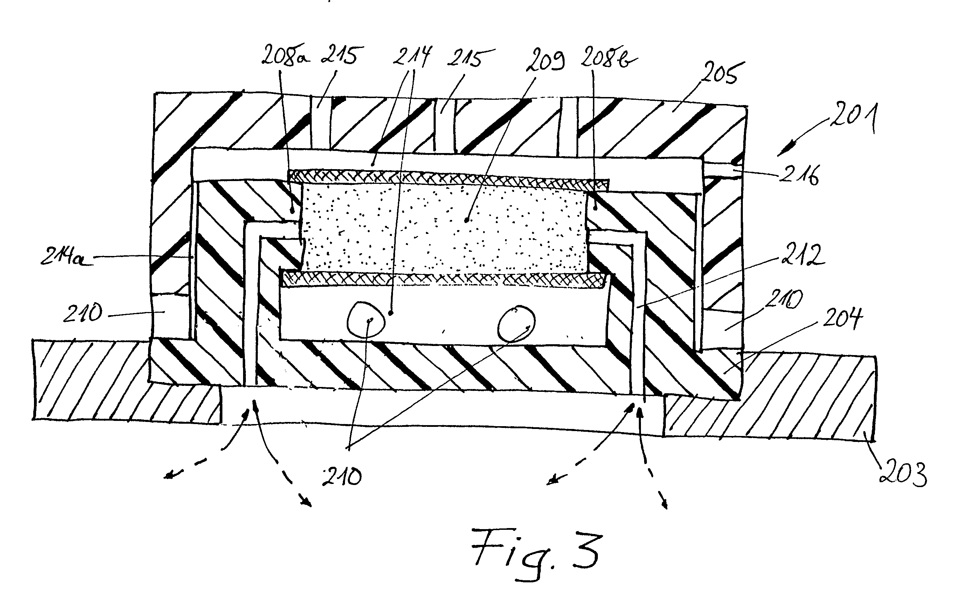

Fig. 2 zeigt eine abgewandelte Ausführungsform einer erfindungsgemäßen Sperrvorrichtung. Die in Fig. 2 dargestellte Sperrvorrichtung 101 besteht aus einem Trägerkörper, welcher wiederum aus einem als Formkörper ausgebildeten Unterteil 104 und einem als Deckel ausgebildeten Oberteil 105 zusammengesetzt ist.

In dem Unterteil 104 befinden sich eine Längsmittelbohrung 112 und davon seitlich nach oben abgehende konische Schrägbohrungen 113, die zusammen mit der Längsmittelbohrung 112 Luftdurchtrittskanäle bilden.

Zwischen den nach oben weisenden Öffnungen der Kanäle 112 und 113 sind mittlere Membran-Auflagebereiche gebildet, die im Verein mit einem Auflagerand 108 des Unterteil 104 eine Aufnahmefläche für eine PTFE-Membran 109 bilden.

Im äußeren Randbereich ist das Unterteil 104 mit einer ringförmigen Stufe ausgebildet. Auf der Unterseite des Unterteils 104 ist ein Einschraubstutzen 103 mit Außengewinde angeformt.

Das als gewölbter Deckel ausgebildete Oberteil 105 besitzt einen umlaufenden Ringflansch 106, der auf seiner Innenseite mit einem Ringwulst 109 ausgebildet ist, der in eine umlaufende Ringnut 118 im Unterteil 104 eingeschnappt ist. Zwischen der Ringnut 118 des Unterteils 104 und dem inneren Ringwulst 117 des Oberteils 105 befindet sich als Dichtungsabschnitt 117 ein äußerer Randbereich der PTFE-Membran 109.

Bei der Montage wird die Membran 109 auf die Auflagefläche 111, 108 des Unterteils 104 des Formkörpers aufgelegt, und anschließend wird das Oberteil 105 aufgeschnappt. Die axiale Länge des Ringflansches 106 ist so bemessen, daß sich zwischen Unterteil 104 und Oberteil 105 eine eine bestimmte Höhe aufweisende gewölbte Kammer 114 ergibt.

Von der Kammer 114 führen nach oben schräglaufende Öffnungen 115 nach außen, Im Bereich des Ringflansches 106 führen Kanäle 116 nach außen. Die Kanäle 115 und 116 dienen sowohl als Luftdurchtrittsöffnungen als auch als Flüssigkeitsablaufkanäle. Die Kanäle 115 und 116 sind so bemessen und orientiert, daß von außen nicht direkt mit einem starren Gegenstand auf die Membran 109 eingewirkt werden kann. Diese Ausgestaltung der Kanäle 115 und 116 ist in Fig. 2 durch die extrem schräge Anordnung der Kanäle 115 in der Oberseite des Deckels 105 angedeutet.

Die Funktionsweise dieser Sperrvorrichtung 101 entspricht der anhand von Fig. 1 erläuterten Funktionsweise.

Fig. 3 zeigt eine weitere Ausführungsform der Erfindung. Zum Befestigen an einem in der Figur nicht dargestellten, abgedichteten Gehäuse dient ein ringförmiger Flansch 203, an welchem ein Trägerkörper angeformt ist. Der Trägerkörper der Sperrvorrichtung 201 besteht aus einem Kunststoff-Unterteil 204 und einem Kunststoff-Oberteil 205.

In dem Unterteil 204 sind zwei im Querschnitt L-förmige Schlauchträgerstutzen 208a und 208b ausgebildet, deren Stirnseiten einander zugewandt sind. Auf den Enden der Schlauchträgerstutzen 208a und 208b sitzen die Enden eines Membran-Schlauchstücks 209 aus PTFE, das flüssigkeitsundruchlässig, jedoch gasdurchlässig ist.

Das Schlauchstück 209 ist von einer Kammer 214 umgeben, die sich zwischen den Schlauchträgerstutzen 208a, 208b, dem Schlauchstück 209 einerseits und der Innenfläche des vorzugsweise rotationssymmetrisch ausgebildeten Oberteils 205 des Trägerkörpers erstreckt. Die Kammer 214 setzt sich zwischen den Außenseiten der Schlauchträgerstutzen 208a und 208b und den diesen gegenüberliegenden Innenseiten des Oberteils 205 fort. Von der Kammer 214 gehen in deren unteren Bereich Flüssigkeitsablaufkanäle 210 und in deren oberen Bereich seitlich Flüssigkeitsablaufkanäle 216 ab. In der Oberwand des Oberteils 205 befinden sich nach oben gerichtete Flüssigkeitsablaufkanäle 215.

Die Funktionsweise der Sperrvorrichtung nach Fig. 3 ist ähnlich der Funktionsweise der Sperrvorrichtung 1 nach Fig. 1 und der Sperrvorrichtung 101 nach Fig. 2.

Die Sperrvorrichtung 101 nach Fig. 2 ist im wesentlichen rotationssymmetrisch ausgebildet.


**Ansprüche**

1. Sperrvorrichtung für abgedichtete Gehäuse, bestehend aus einem Trägerkörper (4, 5; 104, 105; 204, 205) mit mindestens einer Durchdurchtrittsöffnung (12, 13,; 112, 113; 212), in deren Bereich eine wasserundurchlässige und gleichzeitig gasdurchlässige Kunststoffmembran (9; 109; 209) angebracht ist, dadurch gekennzeichnet, daß die Membran (9; 109; 209) nicht-eben ausgebildet und/oder angeordnet ist und mindestens ein Flüssigkeitsablaufkanal (10, 15, 16; 115, 116; 210, 215, 216) vorhanden ist.

2. Sperrvorrichtung nach Anspruch 1, dadurch gekennzeichnet, daß die Membran (9) dachförmig mit mehreren ebenen Flächenabschnitten innerhalb des Trägerkörpers (4, 5) angeordnet ist.

3. Sperrvorrichtung nach Anspruch 1, dadurch gekennzeichnet, daß die Membran (109) konvex gewölbt innerhalb des Trägerkörpers (104, 105) angeordnet ist.

4. Sperrvorrichtung nach Anspruch 1, dadurch gekennzeichnet, daß die Membran als Schlauchstück (209) ausgebildet ist, das in einer in dem Trägerkörper (204, 205) ausgebildeten Kammer (214) mit seinen Enden auf Schlauchträgerstutzen (208a, 208b) sitzt, wobei innerhalb mindestens eines Schlauchträgerstutzens eine Luftdurchtrittsöffnung (212) in das Schlauchstück (209) mündet.

5. Sperrvorrichtung nach einem der Ansprüche 1-4, dadurch gekennzeichnet, daß mehrere Flüssigkeitsablaufkanäle (10, 15, 16; 115, 116; 210, 215, 216) vorhanden sind, so daß unabhängig von der Lage der Sperrvorrichtung (1; 101; 201) mindestens ein Kanal tiefer als die Membran (9; 109; 209) liegt und daß insbesondere in dem Trägerkörper (4, 5) seitlich und nach oben weisende Flüssigkeitsablaufkanäle (10, 15, 16; 115, 116, 210, 215, 216) vorhanden sind.

6. Sperrvorrichtung nach einem der Ansprüche 1-5, dadurch gekennzeichnet, daß die Membran eine PTFE-Membran ist.

7. Sperrvorrichtung nach einem der Ansprüche 1-6, dadurch gekennzeichnet, daß die Flüssigkeitsablaufkanäle (10, 15, 16; 115, 116) derart ausgebildet und angeordnet sind, daß keine direkte mechanische Einwirkung auf die Membran von außen möglich ist.

8. Sperrvorrichtung nach einem der Ansprüche 1-7, dadurch gekennzeichnet, daß der Trägerkörper (4, 5; 104, 105; 204, 205) mit dem abzudichtendem Gehäuse verschweißt, verklebt oder mittels einer Dichtung verbunden wird.

9. Sperrvorrichtung für abgedichtete Gehäuse, bestehend aus einem Trägerkörper mit einer Luftdurchtrittsöffnung, in deren Bereich eine wasserabweisende und gleichzeitig gasdurchlässige Kunststoffmembran angebracht ist, insbesondere Sperrvorrichtung nach einem der Ansprüche 1-8, dadurch gekennzeichnet, daß der Trägerkörper (104, 105) ein Unterteil und ein darauf befestigtes Oberteil besitzt, daß das Unterteil ein Formkörper mit einer Membranauflage (111), während das Oberteil ein Deckel mit Ringflansch (106) ist, der auf den Formkörper aufgeschnappt ist, wozu Formkörper und Ringflansch mit Ringnut (118) bzw. Ringwulst (119) versehen sind, und daß der äußere Randbereich (117) der Membran (109) als Dichtung zwischen Ringnut (118) und Ringwulst (119) liegt.

10. Sperrvorrichtung nach Anspruch 9, dadurch gekennzeichnet, daß die Membranauflage eine kalottenförmig gewölbte Fläche (111) mit einer oder mehreren Luftdurchtrittsöffnungen (112, 113) ist, und daß das Oberteil (105) als gewölbter Deckel (105) ausgebildet ist, der zwischen sich und der Membran (109) eine gewölbte Kammer (114) bildet.

Fig. 1

Fig. 2

208a 215    214 215    209 208b    205

201

216

214a

210

212

210 204

210

203

Fig. 3

EP 0 377 067 A1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 177 334 (K. OKITA)<br>* Anspruch 1 *<br>--- | 1,4,6 | B 01 D 71/30<br>H 05 K 5/02 |
| A | RESEARCH DISCLOSURE<br>Nr. 275, März 1987, Seite 149,<br>Zusammenfassung Nr. 27538, New York,<br>NY, USA; "Water Impervious Vent for<br>Electrical and Similar Equipment"<br>--- | 1,6,9 | |
| A | FR-A-2 157 169 (SUMITOMO ELECTRIC<br>INDUSTRIES LTD.)<br>* ganze Schrift *<br>----- | 1 | |

| | |
|---|---|
| | **RECHERCHIERTE SACHGEBIETE (Int. Cl.5)**<br><br>B 01 D 71/00<br>H 05 K 5/00<br>F 16 K 24/00 |

Der vorliegende Recherchenbericht wurde für alle Patentansprüche erstellt

| Recherchenort | Abschlußdatum der Recherche | Prüfer |
|---|---|---|
| BERLIN | 18-07-1989 | SCHLABBACH M |

EPO FORM 1503 03.82 (P0403)

**KATEGORIE DER GENANNTEN DOKUMENTE**

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
.................................................................
& : Mitglied der gleichen Patentfamilie, übereinstimmendes
    Dokument